(19) Europäisches Patentamt

European Patent Office

Office européen des brevets

(11) **EP 1 440 517 B1**

(12) **EUROPÄISCHE PATENTSCHRIFT**

(45) Veröffentlichungstag und Bekanntmachung des Hinweises auf die Patenterteilung:
**20.09.2006 Patentblatt 2006/38**

(21) Anmeldenummer: **02753031.0**

(22) Anmeldetag: **26.07.2002**

(51) Int Cl.:
**H04B 1/10** *(2006.01)*

(86) Internationale Anmeldenummer:
**PCT/DE2002/002750**

(87) Internationale Veröffentlichungsnummer:
**WO 2003/039012 (08.05.2003 Gazette 2003/19)**

(54) **Adaptives Kanalfilter für Mobilfunkempfänger und Verfahren zur Adaptiven Kanalfilterung**

Adaptive channel filter for a mobile radion receiver, and method for adaptive channel filtering

Filtre de canal adaptatif pour récepteur radio mobile, et procédé de filtrage de canal canal adaptatif

(84) Benannte Vertragsstaaten:
**DE FR GB**

(30) Priorität: **25.10.2001 DE 10152628**

(43) Veröffentlichungstag der Anmeldung:
**28.07.2004 Patentblatt 2004/31**

(73) Patentinhaber: **Infineon Technologies AG
81669 München (DE)**

(72) Erfinder:
• **YANG, Bin
70550 Stuttgart (DE)**
• **WU, Xiaofeng
85579 Neubiberg (DE)**

(74) Vertreter: **Lange, Thomas et al
Patentanwälte
Lambsdorff & Lange
Dingolfinger Strasse 6
81673 München (DE)**

(56) Entgegenhaltungen:
**US-A- 5 287 556          US-A- 5 493 717**

**Beschreibung**

Die Erfindung betrifft eine adaptives Kanalfilter für eine Empfängereinheit eines mobilen Kommunikatonssystems sowie ein Verfahren zum Einstellen einer variablen Durchlassbandbreite eines Kanalfilters.

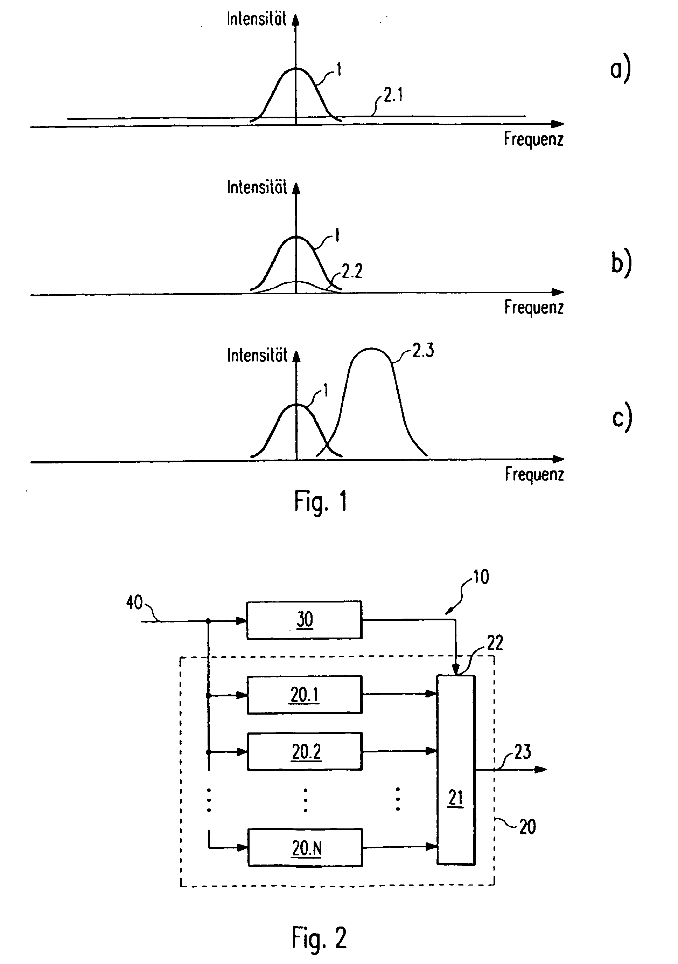

In vielen Mobilfunksystemen wie beispielsweise GSM (Global System for Mobile Communications) und dessen Weiterentwicklung EDGE (Enhanced Data services for GSM Evolution) ist die Gesamtübertragungsbandbreite in eine Vielzahl von schmalbandigen Teilnehmer-Frequenzbändern (Verkehrskanälen) unterteilt. Die Bandbreite eines Teilnehmer-Frequenzbandes beträgt in GSM- und EDGE-Systemen 200 kHz. In den Figuren 1a bis 1c sind drei wichtige Störungseinflüsse beim Empfang eines solchen schmalbandigen Nutzsignals dargestellt.

In den Figuren 1a bis 1c ist jeweils der spektrale Verlauf eines empfangenen Signals 1 in Gegenwart einer Störung 2.1, 2.2 bzw. 2.3 dargestellt. Figur 1a zeigt das schmalbandige empfangene Signal 1 im Beisein von Rauschen, welches eine breitbandige Störung 2.1 repräsentiert. Die Figuren 1b und 1c zeigen zwei Fälle von Vielfachzugriffsinterferenz, auch als MAI (Multiple Access Interference) bezeichnet, nämlich Gleichkanalinterferenz (Figur 1b) und Nachbarkanalinterferenz (Figur 1c). Während bei Gleichkanalinterferenz die Störung 2.2 im gleichen Teilnehmer-Frequenzband wie das gewünschte Signal 1 liegt, und beispielsweise durch einen in einer anderen Zelle des Netzes aktiven Teilnehmer hervorgerufen wird, liegt die Störung 2.3 bei der Nachbarkanalinterferenz in einem der beiden benachbarten Teilnehmer-Frequenzbänder.

Der Einfluß von Nachbarkanalinterferenz wird durch die Kanalbreite der Teilnehmer-Frequenzbänder und die in dem System verwendete Symbolfrequenz beeinflußt. Zur Erzielung einer hohen Teilnehmerkapazität des Systems und einer hohen Datenrate werden schmale Kanalbreiten und hohe Symbolfrequenzen angestrebt. Auf der anderen Seite bewirkt dies eine Erhöhung der Nachbarkanalinterferenz, welche jedoch eine bestimmte Grenze nicht überschreiten darf.

Bei GSM und EDGE beträgt die Symbolfrequenz 270,833 kHz und die Kanalbreite, wie bereits erwähnt, 200 kHz. Dies hat zur Folge, dass das gewünschte Signal 1 und die Störung 2.3 durch Nachbarkanalinterferenz einander spektral überlappen, siehe Figur 1c. Es ist nicht möglich, die Nachbarkanalinterferenz vollständig zu unterdrücken ohne das Spektrum des gewünschten Signals 1 einzuengen.

In herkömmlichen Empfängern von mobilen Kommunikationssystemen weist das für das Herausfiltern des gewünschten Teilnehmer-Frequenzbandes verwendete Kanalfilter eine feste, vorgegebene Bandbreite auf. Die gewählte Bandbreite stellt einen Kompromiß zwischen den einander entgegenlaufenden Zielen einer möglichst guten Ausnutzung des Teilnehmer-Frequenzbandes zur Signaldetektion und einer möglichst guten Unterdrückung von Nachbarkanalinterferenz dar. Dieser Kompromiß ist in vielen Empfangssituationen notwendigerweise suboptimal.

Der Erfindung liegt die Aufgabe zugrunde, ein Kanalfilter zu schaffen, welches eine ausreichend hohe Unterdrückung von Nachbarkanalinterferenz unter Beibehaltung einer ausreichenden Bandbreite ermöglicht. Insbesondere soll ein kostengünstige Lösung gefunden werden. Ferner zielt die Erfindung darauf ab, ein Verfahren zur Kanalfilterung mit den genannten Eigenschaften anzugeben.

Die der Erfindung zugrunde liegende Aufgabenstellung wird durch die Merkmale der unabhängigen Ansprüche gelöst.

Durch die Steuerung der Durchlassbandbreite des Kanalfilters in Abhängigkeit von der Nachbarkanalinterferenz, d.h. allgemein einer durch die Stärke der Nachbarkanalinterferenz beeinflussten Größe, wird ein adaptives Kanalfilter geschaffen, mit welchem bei unterschiedlichen Empfangs- bzw. Interferenzsituationen stets eine optimale Filterung des gewünschten Signals durchgeführt werden kann. Dabei ist das erfindungsgemäße adaptive Kanalfilter ein digitales Tiefpassfilter im Basisbandabschnitt der Empfängereinheit. Die variable Durchlassbandbreite wird durch eine variable obere Abschneidefrequenz des Tiefpassfilters realisiert. Kern der Erfindung ist, dass ein Eingang des Mittels zur Steuerung der Durchlassbandbreite mit dem Ausgang eines zusätzlichen, dem Kanalfilter parallel geschalteten digitalen Bandpassfilters verbunden ist. Die Verwendung eines externen (bezüglich des Kanalfilters mit variabler Durchlassbandbreite) digitalen Bandpassfilters erhöht zwar den Realisierungsaufwand der Schaltung, ermöglicht jedoch eine höhere Genauigkeit bzw. Verläßlichkeit beim Steuern der Durchlassbandbreite. Der Vorteil dieser Anordnung besteht darin, dass das Bandpassfilter so ausgelegt werden kann, dass es genau denjenigen Teil der Signalleistung extrahiert, welcher am aussagekräftigsten ist.

Neben der (zwingend erforderlichen) Abhängigkeit der Steuerung der Durchlassbandbreite des Kanalfilters von der Nachbarkanalinterferenz können auch weitere Einflußgrößen zum Steuern der Durchlassbandbreite des Kanalfilters berücksichtigt werden. In dieser Hinsicht kennzeichnet sich eine vorteilhafte Ausführungsvariante des adaptiven Kanalfilters dadurch aus, dass das Mittel zum Steuern der Durchlassbandbreite auch das Rauschen, insbesondere dessen Stärke, berücksichtigt.

Zweckmäßigerweise ist in diesem Fall das Mittel zum Steuern der Durchlassbandbreite ausgelegt, bei hoher Nachbarkanalinterferenz eine erste, geringe Durchlassbandbreite des Kanalfilters einzustellen, bei geringer Nachbarkanalinterferenz und geringem Rauschen eine zweite Durchlassbandbreite einzustellen, die größer als die erste Durchlassbandbreite ist, und bei geringer Nachbarkanalinterferenz und über die Nachbarkanalinterferenz dominierendem Rauschen eine dritte Durchlassbandbreite einzustellen, die größer als die erste und kleiner als die zweite Durchlassbandbreite ist. Durch die (maßvolle) Reduzierung der Durchlassbandbreite bei erhöhtem Rauschpegel wird die Rauschbandbreite des empfangenen Signals reduziert, ohne dabei jedoch eine allzu große Signalverzerrung zu verursachen.

Für geeignete konstruktive Ausbildungen des Kanalfilters stehen verschiedene Möglichkeiten zur Wahl, Nach einer ersten vorteilhaften Ausführungsvariante umfaßt das Kanalfilter eine Mehrzahl von parallel zueinander angeordneten Filtern mit unterschiedlichen, festen Durchlassbandbreiten und einen Wahlschalter, dessen Eingänge mit den Ausgängen der Filter verbunden sind. Eine zweite, ebenfalls bevorzugte Variante kennzeichnet sich dadurch, dass das Kanalfilter eine Mehrzahl von seriell zueinander angeordneten, die Bandbreite schrittweise einengenden Filtern und einen Wahlschalter umfaßt, dessen Eingänge mit Signalabgriffen zwischen den Filtern verbunden sind. Die zweite, kaskadierte Variante bietet gegenüber der ersten Variante den Vorteil, dass die nachgeordneten Filter zur weiteren Einengung der Bandbreite eine geringere Komplexität als ein Einzelfilter, welches die gleiche Übertragungsfunktion bewirkt, aufweisen können.

Das Mittel zum Steuern der Durchlassbandbreite weist vorzugsweise ein Berechnungsmittel mit wenigstens zwei Eingängen auf, wobei das Berechnungsmittel für jeden Eingang eine Größe berechnet, die für die diesem Eingang zugeführte Leistung repräsentativ ist, und enthält ferner ein Vergleichsmittel, welches für unterschiedliche Eingänge berechnete Größen miteinander vergleicht.

Nach einer vorteilhaften Realisierungsmöglichkeit des adaptiven Kanalfilters sind ein oder mehrere Eingänge des Berechnungsmittels einem oder mehreren Eingängen des Wahlschalters parallel geschaltet. In diesem Fall werden direkt die Signal leistungen bzw. die für die Signalleistungen repräsentativen Größen aus einzelnen Filterzweigen für die Auswertung herangezogen.

Das erfindungsgemäße Verfahren kennzeichnet sich durch die Schritte des Messens einer von Nachbarkanalinterferenz beeinflußten Größe und des Einstellens der Durchlassbandbreite des Kanalfilters in Abhängigkeit von der gemessenen Größe, wobei der Kanalfilter ein digitales Tiefpassfilter im Basisbandabschnitt der Empfängereinheit ist. Das Messer der von Nachbarkanalinterfenz beinflußten Größe erfolgt mit Hilfe eines zusatzlichen, dem Kanalfilter mit variabler Durchlassbandbreite parallel geschalteten digitalen Bandpassfilters. Durch die Berücksichtigung der Nachbarkanalinterferenz beim Einstellen der Durchlassbandbreite kann.ein optimaler Kompromiß zwischen der bandbreitenausnutzung und Interferenzunterdrückung erreicht und durch Nachführen aufrecht erhalten werden.

Eine weitere vorteilhafte Ausgestaltung des erfindungsgemäßen Verfahrens kennzeichnet sich dadurch, dass die Zeitdauer der Messung der Zeitdauer eines Bursts entspricht.

Weitere vorteilhafte Ausgestaltungen der Erfindung sind in den Unteransprüchen angegeben.

Nachfolgend wird die Erfindung anhand von Ausführungsbeispielen unter Bezugnahme auf die Zeichnung erläutert; in dieser zeigt:

Fig. 1a bis 1c Signalspektren in Gegenwart verschiedener Störungsquellen, nämlich breitbandigem Rauschen, Gleichkanalinterferenz und Nachbarkanalinterferenz;

Fig. 2 ein Blockschaltbild zur Erläuterung des allgemeinen Aufbaus eines adaptiven Kanalfilters;

Fig. 3 ein Blockschaltbild eines ersten Ausführungsbeispiels eines adaptiven Kanalfilters mit zwei unterschiedlichen Filtercharakteristiken;

Fig. 4 ein Blockschaltbild eines zweites Ausführungsbeispiels eines adaptiven Kanalfilters mit zwei unterschiedlichen Filtercharakteristiken; und

Fig. 5 ein Blockschaltbild einer Realisierungsmöglichkeit eines Steuerschaltkreises des adaptiven Kanalfilters.

Figur 2 zeigt anhand eines vereinfachten Blockschaltbilds das Grundprinzip eines adaptiven Kanalfilters 10. Das adaptive Kanalfilter 10 umfaßt ein Filter 20 mit einstellbarer Durchlassbandbreite und eine Steuereinrichtung 30 zur Einstellung der Durchlassbandbreite des Filters 20.

Das adaptive Kanalfilter 10 ist vorzugsweise ein digitales Tiefpassfilter, welches sich im Basisband-Verarbeitungsabschnitt eines Mobilfunkempfängers befindet. Das dem adaptiven Kanalfilter 10 zugeführte Signal 40 ist beispielsweise durch geeignetes Heruntermischen der Frequenz des gewünschten Teilnehmer-Frequenzbandes in das Basisband bereits frequenz- bzw. teilnehmerselektiert, jedoch noch nicht oder nicht ausreichend bandbreitenbegrenzt.

Das Filter 20 mit einstellbarer Durchlassbandbreite umfaßt eine Anzahl N von Kanalfilter 20.1, 20.2, ..., 20.N mit fest vorgegebenen, unterschiedlichen Durchlassbandbreiten. Im Falle der hier betrachteten Basisbandverarbeitung sind die Kanalfilter 20.1, ..., 20.N Tiefpassfilter mit unterschiedlichen Abschneidefrequenzen. Die Ausgänge der N Tiefpassfilter 20.1, ..., 20.N werden den Eingängen eines Wahlschalters 21 zugeleitet. Der Wahlschalter 21 weist einen Steuereingang 22 auf, über welchen eines der zugeführten Filtersignale ausgewählt und an einen Ausgang 23 des Filters 20 mit einstellbarer Durchlassbandbreite geschaltet werden kann.

Die Filtercharakteristiken der Tiefpassfilter 20.1, ..., 20.N sind unterschiedlichen Interferenz- und ggf. Rauschsituationen angepasst. Die Steuereinrichtung 30 führt für jeden Burst des Signals 40 eine Signalverarbeitung durch, welche das aktuelle Verhältnis der Leistung des gewünschten Signals zu der Nachbarkanalinterferenzleistung schätzt. Abhängig von dieser Messung wird vom Wahlschalter 21 ein geeigneter Filterausgang ausgewählt und auf den Ausgang 23 gelegt. Zu diesem Zweck steht ein Ausgang der Steuereinrichtung 30 mit dem Steuereingang 22 des Wahlschalters 21 in Verbindung.

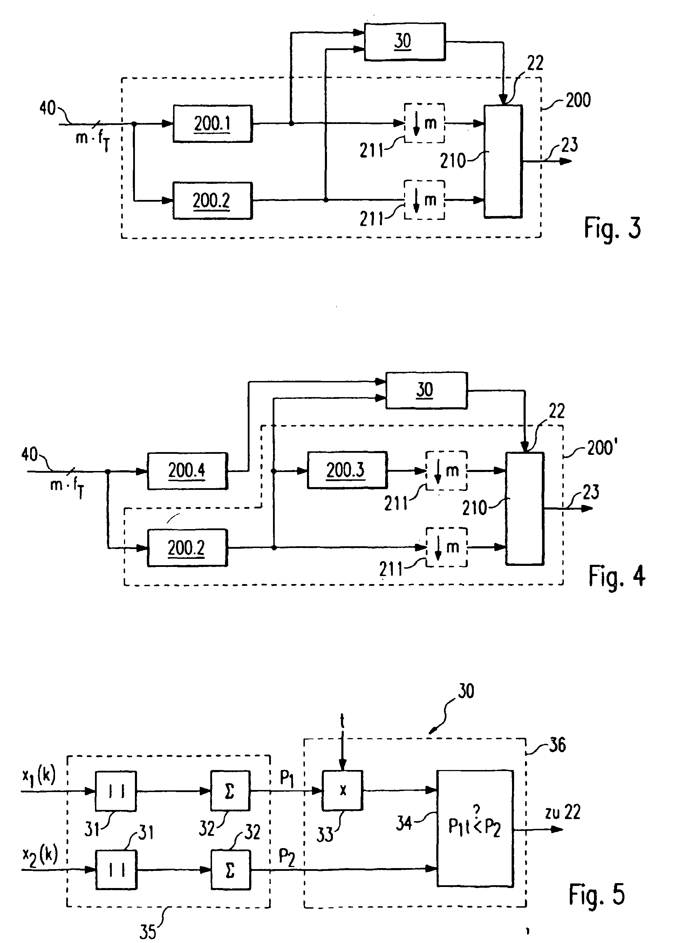

Figur 3 zeigt ein erstes Ausführungsbeispiel der Erfindung für den einfachsten Fall N = 2. Dieselben oder vergleichbare Bauelemente sind mit den gleichen Bezugszeichen wie in Figur 2 bezeichnet. Das Filter 200 mit einstellbarer Durchlassbandbreite weist ein erstes Tiefpassfilter 200.1 und ein zweites Tiefpassfilter 200.2 auf. Beiden Tiefpassfiltern 200.1 und 200.2 wird das Signal 40 zugeführt. Die Abschneidefrequenz des Tiefpassfilters 200.1 liegt etwas tiefer als die Abschneidefrequenz des Tiefpassfilters 200.2.

Die Ausgänge beider Tiefpassfilter 200.1 und 200.2 werden der Steuereinrichtung 30 zugeleitet. Die Steuereinrichtung 30 mißt die Signalleistung dieser beiden Signale und führt einen Vergleich der gemessenen Leistungen durch. Das Ergebnis des Vergleichs wird dem Wahlschalter 210 über dessen Steuereingang 22 zugeleitet. In Abhängigkeit von dem Vergleichsergebnis wird einer der Schaltereingänge ausgewählt und an den Ausgang 23 des Filters 200 gelegt.

In Figur 3 wird angenommen, dass die Taktrate des Signals 40 $m.f_T$ beträgt. $f_T$ bezeichnet die Symbolfrequenz und beträgt für GSM und EDGE 270.833kHz. m bezeichnet den Überabtastfaktor. Für ein Kanalfilter im Basisband ist typischerweise m = 2. Figur 3 zeigt, dass bei einer Überabtastung mit dem Faktor m eine optionale Signaldezimation zwischen jeweils den Tiefpassfiltern 200.1 und 200.2 und dem Wahlschalter 210 erfolgen kann. Die (optionale) Dezimation wird durch die Dezimatoren 211 bewirkt. Die Wirkungsweise jedes Dezimators 211 besteht darin, aus einer Gruppe von m Abtastwerten lediglich einen Abtastwert zum Ausgang weiterzugeben und die verbleibenden m-1 Abtastwerte zu verwerfen. Die Signaldezimation ist nur dann erforderlich, wenn hinter dem adaptiven Kanalfilter 10 eine Signalverarbeitung im Symboltakt vorgesehen ist.

Die Wirkungsweise des in Figur 3 dargestellten Ausführungsbeispiels ist wie folgt:

Sofern eine starke Nachbarkanalinterferenz vorhanden ist, ist die Leistung des von dem Tiefpassfilter 200.2 mit höherer Abschneidefrequenz ausgegebenen Signals deutlich größer als die Leistung des von dem Tiefpassfilter 200.1 mit tieferer Abschneidefrequenz ausgegebenen Signals. Ursache hierfür ist, dass eine höhere Interferenzleistung das Tiefpassfilter 200.2 passiert als das Tiefpassfilter 200.1. Wenn das Verhältnis der beiden Signalleistungen einen vom Benutzer definierten Schwellenwert überschreitet, wird der Wahlschalter 210 von der Steuereinrichtung 30 so angesteuert, dass der Ausgang des Tiefpassfilters 200.1 mit der tieferen Abschneidefrequenz an den Ausgang 23 des Filters 200 gelegt wird. Andernfalls, d.h. bei geringer oder verschwindender Nachbarkanalinterferenz, sind die Leistungen der beiden gefilterten Signale nahezu identisch. Das Verhältnis der beiden Leistungen liegt dann unterhalb des vorgegebenen Schwellenwertes, woraufhin der Ausgang des anderen Tiefpassfilters 200.2 mit höherer Abschneidefrequenz von dem Wahlschalter 210 angewählt und an den Ausgang 23 gelegt wird.

Die Abschneidefrequenzen der Tiefpassfilter 200.1 und 200.2 sind dabei so gewählt, dass das zweite Tiefpassfilter 200.2 das gewünschte Signal ohne Verzerrungen überträgt, sofern keine Nachbarkanalinterferenz vorhanden ist, während das erste Tiefpassfilter 200.1 starke Nachbarkanalinterferenzen unterdrückt. Dabei schneidet das erste Tiefpassfilter 200.1 auch einen Randbereich des Spektrums des gewünschten Signals ab, wodurch eine beabsichtigte Signalverzerrung entsteht. Diese beabsichtigte Signalverzerrung ist jedoch sehr viel geringer als die Verzerrung, die die Nachbarkanalinterferenz verursachen würde, wenn sie nicht durch das Tiefpassfilter 200.1 unterdrückt würde.

Figur 4 zeigt ein zweites Ausführungsbeispiel eines erfindungsgemäßen, adaptiven Kanalfilters. Dieses Ausführungsbeispiel unterscheidet sich von dem in Figur 3 gezeigten und vorstehend erläuterten Ausführungsbeispiel im wesentlichen durch zwei Aspekte:

1.) Anstelle der Verwendung von zwei unabhängigen Tiefpassfiltern (200.1 und 200.2) mit unterschiedlichen Abschneidefrequenzen wird bei dem in Figur 4 dargestellten Ausführungsbeispiel eine kaskadierte Filteranordnung eingesetzt. Das Tiefpassfilter 200.2 entspricht dem Filter 200.2 in Figur 3 und weist wie dieses eine hohen Abschneidefrequenz auf. Anstelle des Tiefpassfilters 200.1 mit tiefer Abschneidefrequenz wird jedoch eine serielle Anordnung des Tiefpassfilters 200.2 und eines nachgeschalteten Einengungs- oder Begrenzungsfilters 200.3 verwendet. Das Einengungsfilter 200.3 hat die Funktion, den spektralen Durchlassbereich des Tiefpassfilters 200.2 etwas zu verkleinern, d.h. die serielle Anordnung der Filter 200.2 und 200.3 verhält sich ähnlich wie das einzelne Tiefpassfilter 200.1 mit tiefer Abschneidefrequenz. Der Vorteil der Kaskadenlösung besteht darin, dass das Einengungsfilter 200.3 eine geringere Komplexität als das Tiefpassfilter 200.1 aufweist, d.h. hinsichtlich des Filters 200' mit einstellbarer Durchlassbandbreite eine kostengünstigere Realisierung vorliegt.

2.) Der zweite Aspekt, welcher die beiden Ausführungsbeispiele unterscheidet, besteht darin, dass die Steuereinrichtung 30 nicht wie bei dem in Figur 3 gezeigten Ausführungsbeispiel die Signalleistungen der beiden dem Wahlschalter 210 zugeführten Filterausgänge vergleicht. Statt dessen wird ein Bandpassfilter 200.4 eingesetzt, dem eingangsseitig das Signal 40 zugeführt wird und dessen Ausgang mit einem Eingang der Steuereinrichtung 30 verbunden ist. Der andere Eingang der Steuereinrichtung 30 ist weiterhin mit dem Ausgang des Tiefpassfilters 200.2 mit der höheren Abschneidefrequenz verbunden. Der Vorteil dieser Anordnung besteht darin, dass das Bandpassfilter 200.4 so ausgelegt werden kann, dass es genau denjenigen Teil der Signalleistung extrahiert, welcher für einen Leistungsvergleich in der Steuereinrichtung 30 am aussagekräftigsten ist. Durch Simulationen konnte gezeigt werden, dass auf diese Weise die Genauigkeit der Steuereinrichtung 30 erhöht werden kann.

Es wird darauf hingewiesen, dass die beiden Ausführungsbeispiele nicht alternativ sind. D.h., ein erfindungsgemäßes Filter 20, 200, 200' mit einstellbarer Durchlassbandbreite kann ohne weiteres einen gemischt parallelen und seriellen Aufbau aufweisen. Ferner kann die anhand Figur 4 veranschaulichte Ansteuerung der Steuereinrichtung 30 selbstverständlich auch bei dem in Figur 3 dargestellten Filter 200 mit parallelem Aufbau vorgesehen sein, und die in Figur 3 dargestellte Ansteuerung der Steuereinrichtung 30 ist genau so gut bei der in Figur 4 dargestellten Ausführungsvariante mit seriellem Filterkonzept realisierbar.

Figur 5 zeigt eine kostengünstige Realisierungsmöglichkeit der Steuereinrichtung 30 in Form eines Blockschaltbildes. Den beiden Basisband-Eingängen der Steuereinrichtung 30 werden die von den Filtern 200.1 und 200.2 bzw. 200.4 und 200.2 berechneten komplexen Abtastwerte $x_1(k)$ und $x_2(k)$ zugeleitet. Bei dem in Figur 4 dargestellten Beispiel werden die Abtastwerte $x_1(k)$ von dem Bandpassfilter 200.4 und die Abtastwerte $x_2(k)$ von dem Tiefpassfilter 200.2 mit hoher Abschneidefrequenz erzeugt. Die Steuereinrichtung 30 weist in jedem Signalzweig einen Betragsbildner 31 und einen Akkumulator 32 auf. Dem Akkumulator 32 des den Abtastwerten $x_1(k)$ zugeordneten Zweigs ist ein Multiplizierer 33 nachgeschaltet, welcher die Abtastwerte mit einem vom Nutzer definierbaren Schwellenwert-Vorgabewert t multipliziert. Der Ausgang des Multiplizierers 33 und der Ausgang des Akkumulators 32 des anderen Zweigs werden beiden Eingängen eines Komparators 34 zugeführt. Der Komparator 34 überprüft, welcher der beiden Eingänge einen größeren Wert aufweist und stellt an seinem Ausgang ein entsprechendes Vergleichssignal bereit. Dieses wird in der bereits dargestellten Weise als Steuersignal dem Eingang 22 des Wahlschalters 21, 210 zugeführt.

Die aus den Betragsbildnern 31 und Akkumulatoren 32 aufgebaute Schaltung ist in Figur 5 als Berechnungsschaltkreis 35 dargestellt. Der Komparator 34 mit vorgeschaltetem Multiplizierer 33 bildet eine Vergleichsschaltung 36 mit einstellbarem Schwellenwert.

Der Berechnungsschaltkreis 35 berechnet die Summe der Beträge der Real- und Imaginärteile beider Eingangssignale über die Akkumulationsdauer, welche beispielsweise die Dauer eines Bursts ist. In diesem Fall wird ein burstsweise adaptives Verhalten des adaptiven Kanalfilters 10 erreicht. Die Gleichung für die Berechnung der Ausgangsgrößen $P_1$ bzw. $P_2$ des Berechnungsschaltkreises 35 lautet:

$$P_i = \sum_{k=1,\ldots,K} \left( \left| \mathrm{Re}\left( x_i(k) \right) \right| + \left| \mathrm{Im}\left( x_i(k) \right) \right| \right) \qquad (i = 1,\ldots,N)$$

wobei N die Anzahl der Eingänge des Berechnungsschaltkreises 35, $x_i(k)$ die dem i-ten Eingang des Berechnungsschaltkreises 35 zugeführten Abtastwerte mit Zeitindex k und K die Anzahl der Abtastwerte eines Bursts sind.

Die Größen $P_1$ und $P_2$ dienen als Schätzungen für die jeweiligen Signalleistungen. Die Größe $P_1$ wird vom Multiplizierer 33 mit dem Schwellenwert-Vorgabewert t multipliziert. Im Komparator 34 wird die Größe $P_1 \cdot t$ mit der Größe $P_2$ verglichen.

Das in Figur 4 dargestellte adaptive Kanalfilter wurde in GSM- und EDGE-Empfängern implementiert. Für das Bandpassfilter 200.4 wurde ein IIR-(Infinite Impulse Response-)Filter mit neun Koeffizienten eingesetzt. Das Tiefpassfilter 200.2 mit hoher Abschneidefrequenz wurde als lineares FIR-(Finite Impulse Response-)Phasenfilter mit dreiunddreißig symmetrischen Koeffizienten ausgeführt. Das Einengungsfilter 200.4 wurde als lineares FIR-Phasenfilter mit dreizehn symmetrischen Koeffizienten gewählt. Die im Empfänger verwendete Überabtastung betrug m = 2. Das erfindungsgemäße, adaptive Kanalfilter brachte eine wesentliche Verbesserung im realen Empfangsbetrieb bei Situationen mit zeitlich wechselnder Nachbarkanalinterferenz.

**Patentansprüche**

1.  Adaptives Kanalfilter für eine Empfängereinheit eines mobilen Kommunikationssystems, welches aufweist:

- ein Kanalfilter (20, 200, 200') mit variabler Durchlassbandbreite,
- ein digitales Bandpassfilter (200.4), das dem Kanalfilter (200') mit variabler Durchlassbandbreite parallel geschaltet ist, und
- ein Mittel (30) zum Steuern der Durchlassbandbreite des Kanalfilters (20, 200, 200') in Abhängigkeit von der Nachbarkanalinterferenz, wobei
- wenigstens ein Eingang des Mittels (30) zum Steuern der Durchlassbandbreite mit dem Ausgang des digitalen Bandpassfilters (200.4) verbunden ist,

**dadurch gekennzeichnet,**

- **dass** das Kanalfilter (20, 200, 200') ein digitales Tiefpassfilter im Basisbandabschnitt der Empfängereinheit ist.

2. Adaptives Kanalfilter nach Anspruch 1,
**dadurch gekennzeichnet,**

- **dass** das Mittel (30) zum Steuern der Durchlassbandbreite ausgelegt ist, neben der Nachbarkanalinterferenz auch das Rauschen zu berücksichtigen.

3. Adaptives Kanalfilter nach Anspruch 2,
**dadurch gekennzeichnet,**

- **dass** das Mittel (30) zum Steuern der Durchlassbandbreite ausgelegt ist,

-- bei hoher Nachbarkanalinterferenz eine erste, geringe Durchlassbandbreite einzustellen,
-- bei geringer Nachbarkanalinterferenz und geringem Rauschen eine zweite Durchlassbandbreite einzustellen, die größer als die erste Durchlassbandbreite ist, und
-- bei geringer Nachbarkanalinterferenz und über die Nachbarkanalinterferenz dominierendem Rauschen eine dritte Durchlassbandbreite einzustellen, die größer als die erste und kleiner als die zweite Durchlassbandbreite ist.

4. Adaptives Kanalfilter nach einem der vorhergehenden Anprüche,
**dadurch gekennzeichnet,**

- **dass** das Kanalfilter (20, 200) mit variabler Durchlassbandbreite eine Mehrzahl von parallel zueinander angeordneten Filtern (20.1-20.N; 200.1, 200.2) mit unterschiedlichen, festen Durchlassbandbreiten und einen Wahlschalter (21, 210) umfasst, dessen Eingänge mit den Ausgängen der Filter (20.1-20.N; 200.1-200.N) verbunden sind.

5. Adaptives Kanalfilter nach einem der Ansprüche 1 bis 4,
**dadurch gekennzeichnet,**

- **dass** das Kanalfilter (200') mit variabler Durchlassbandbreite eine Mehrzahl von seriell zueinander angeordneten, die Bandbreite schrittweise eingrenzenden Filtern (200.2, 200.3) und einen Wahlschalter (210) umfasst, dessen Eingänge zumindest teilweise mit Signalabgriffen zwischen den Filtern (200.2, 200.3) verbunden sind.

6. Adaptives Kanalfilter nach einem der vorhergehenden Ansprüche,
**dadurch gekennzeichnet,**

- **dass** das Mittel zum Steuern (30) der Durchlassbandbreite aufweist:

-- ein Berechnungsmittel (35) mit wenigstens zwei Eingängen, welches ausgelegt ist für jeden Eingang eine Größe zu berechnen, die für die diesem Eingang zugeführte Leistung repräsentativ ist, und
-- ein Vergleichsmittel (36), welches ausgelegt ist für unterschiedliche Eingänge berechnete Größen miteinander zu vergleichen.

7. Adaptives Kanalfilter nach den Ansprüchen 5 und 6,
**dadurch gekennzeichnet,**

- **dass** ein oder mehrere Eingänge des Berechnungsmittels (35) einem oder mehreren Eingängen des Wahlschalters (21, 210) parallel geschaltet sind.

8. Adaptives Kanalfilter nach einem der Ansprüche 6 oder 7,
   **dadurch gekennzeichnet,**

   - **dass** die von dem Berechnungsmittel (35) für jeden Eingang berechnete Größe

$$P_i = \sum_{k=1,\dots,K} \left( |Re(x_i(k))| + |Im(x_i(k))| \right) \qquad (i = 1,\dots,N)$$

   ist, wobei N die Anzahl der Eingänge des Berechnungsmittels (35), $x_i(k)$ die dem i-ten Eingang des Berechnungsmittels (35) zugeführten Abtastwerte und K die Anzahl der einem Burst zugeordneten Abtastwerte sind.

9. Verfahren zum Einstellen der variablen Durchlassbandbreite eines Kanalfilters (20, 200, 200'), welches ein digitales Tiefpassfilter im Basisbandabschnitt der Empfängereinheit ist, mit den Schritten:

   - Messen einer von der Nachbarkanalinterferenz beeinflussten Größe mit Hilfe eines zusätzlichen, dem Kanalfilter (200') mit variabler Durchlassbandbreite parallel geschalteten digitalen Bandpasefilters (200.4),
   - Einstellen der Durchlassbandbreite des Kanalfilters (20, 200, 200') in Abhängigkeit von der gemessenen Größe.

10. Verfahren nach Anspruch 9,
    wobei das Messen den Schritt umfasst:

    - Berechnen von zumindest zwei Größen ($P_1$, $P_2$), die für die Signalleistungen von zumindest zwei mit unterschiedlichen Filtern gefilterten Signalen charakteristisch sind.

11. Verfahren nach Anspruch 9 oder 10,
    wobei das Einstellen der Durchlassbandbreite des Kanalfilters (20, 200, 200') den Schritt umfasst:

    - Vergleichen der gemessenen und gegebenenfalls geeignet skalierten Größen,
    - Ansteuern eines Wahlschalters (21, 210) in Abhängigkeit von dem Vergleichsergebnis.

12. Verfahren nach einem der Ansprüche 9 bis 11,
    wobei die Zeitdauer der Messung der Zeitdauer eines Bursts entspricht.

**Claims**

1. Adaptive channel filter for a receiver unit for a mobile communication system, which has:

   - a channel filter (20, 200, 200') with a variable pass bandwidth,
   - a digital bandpass filter (200.4) which is connected in parallel with the channel filter (200') with a variable pass bandwidth, and
   - a means (30) for controlling the pass bandwidth of the channel filter (20, 200, 200') as a function of the adjacent-channel interference, in which case
   - at least one input of the means (30) for controlling the pass bandwidth is connected to the output of the digital bandpass filter (200.4)

   **characterized**

   - **in that** the channel filter (20, 200, 200') is a digital low-pass filter in the baseband section of the receiver unit.

2. Adaptive channel filter according to Claim 1,
   **characterized**

- **in that** the means (30) for controlling the pass bandwidth is designed to take account of both the adjacent-channel interference and the noise.

3. Adaptive channel filter according to Claim 2, **characterized**

- **in that** the means (30) for controlling the pass bandwidth is designed

-- to set a first, narrow pass bandwidth when the adjacent-channel interference is high,
-- to set a second pass bandwidth, which is wider than the first pass bandwidth, when the adjacent-channel interference is low and the noise is low, and
-- to set a third pass bandwidth, which is wider than the first and narrower than the second pass bandwidth, when the adjacent-channel interference is low and noise is dominant over the adjacent-channel interference.

4. Adaptive channel filter according to one of the preceding claims, **characterized**

- **in that** the channel filter (20, 200) with a variable pass bandwidth comprises a plurality of filters (20.1-20.N; 200.1, 200.2) which are arranged in parallel with one another and have different, fixed pass bandwidths, and a selection switch (21, 210) whose inputs are connected to the outputs of the filters (20.1-20.N; 200.1, 200.N).

5. Adaptive channel filter according to one of Claims 1 to 4, **characterized**

- **in that** the channel filter (200') with a variable pass bandwidth comprises a plurality of filters (200.2, 200.3), which are arranged in series with one another and restrict the bandwidth in steps, and a selection switch (210), at least some of whose inputs are connected to signal taps between the filters (200.2, 200.3).

6. Adaptive channel filter according to one of the preceding claims, **characterized**

- **in that** the means for controlling (30) the pass bandwidth has:

-- a calculation means (35) with at least two inputs, which is designed to calculate a variable for each input, which variable is representative of the power supplied to this input, and
-- a comparison means (36) which is designed to compare variables calculated for different inputs with one another.

7. Adaptive channel filter according to Claims 5 and 6, **characterized**

- **in that** one or more inputs of the calculation means (35) is or are connected in parallel with one or more inputs of the selection switch (21, 210).

8. Adaptive channel filter according to one of Claims 6 or 7, **characterized**

- **in that** the variable which is calculated by the calculation means (35) for each input is:

$$P_i = \sum_{k=1,..,K} \left( \left| Re\,(x_i(k)) \right| + \left| Im\,(x_i(k)) \right| \right) \qquad (i = 1,..,N)$$

where N is the number of inputs of the calculation means (35), $x_i(k)$ is the sample values which are supplied to the i-th input of the calculation means (35), and K is the number of sample values associated with one burst.

9. Method for setting the variable pass bandwidth of a channel filter (20, 200, 200') which is a digital low-pass filter in the baseband section of the receiver unit, having the following steps:

- measurement of a variable which is influenced by the adjacent-channel interference, with the aid of an additional digital bandpass filter (200.4), which is connected in parallel with the channel filter (200') with a variable pass bandwidth,
- setting of the pass bandwidth of the channel filter (20, 200, 200') as a function of the measured variable.

**10.** Method according to Claim 9,
in which the measurement comprises the following step:

- calculation of at least two variables ($P_1$, $P_2$), which are characteristic of the signal powers of at least two signals which are filtered using different filters.

**11.** Method according to Claim 9 or 10,
in which the setting of the pass bandwidth of the channel filter (20, 200, 200') comprises the following step:

- comparison of the measured and possibly suitably scaled variables,
- drive of a selection switch (21, 210) as a function of the comparison result.

**12.** Method according to one of Claims 9 to 11,
in which the time duration of the measurement corresponds to the time duration of a burst.


**Revendications**

**1.** Filtre de canal adaptatif pour une unité de réception d'un système de communication mobile, lequel filtre de canal adaptatif comporte :

- un filtre de canal (20, 200, 200') de largeur de bande passante variable,
- un filtre passe-bande numérique (200.4) qui est monté en parallèle avec le filtre de canal (200') de largeur de bande passante variable, et
- un moyen (30) destiné à commander la largeur de bande passante du filtre de canal (20, 200, 200') en fonction de l'interférence due au canal voisin,
- au moins une entrée du moyen (30) destiné à commander la largeur de bande passante étant reliée à la sortie du filtre passe-bande numérique (200.4),

**caractérisé en ce que** le filtre de canal (20, 200, 200') est un filtre passe-bas numérique dans la portion de bande de base de l'unité de réception.

**2.** Filtre de canal adaptatif selon la revendication 1, **caractérisé en ce que** le moyen (30) destiné à commander la largeur de bande passante est conçu pour tenir compte, en plus de l'interférence due au canal voisin, également du bruit.

**3.** Filtre de canal adaptatif selon la revendication 2, **caractérisé en ce que**

- le moyen (30) destiné à commander la largeur de bande passante est conçu

-- pour régler une première largeur de bande passante petite lorsque l'interférence due au canal voisin est élevée,
-- pour régler une deuxième bande passante, supérieure à la première largeur de bande passante, lorsque l'interférence due au canal voisin est faible et que le bruit est faible, et
-- pour régler une troisième largeur de bande passante, supérieure aux première et deuxième largeurs de bande passante, lorsque l'interférence due au canal voisin est faible et que le bruit est dominant par rapport à l'interférence due au canal voisin.

**4.** Filtre de canal adaptatif selon l'une des revendications précédentes,
**caractérisé en ce que**

- le filtre de canal (20, 200) de largeur de bande passante variable comporte une pluralité de filtres (20.1-20.N ; 200.1, 200.2) montés en parallèle et présentant des largeurs de bande passante fixes différentes et un sélecteur (21, 210) dont les entrées sont reliées aux sorties des filtres (20.1-20.N;200.1,200.2).

**5.** Filtre de canal adaptatif selon l'une des revendications 1 à 4,
**caractérisé en ce que**

- le filtre de canal (200') de largeur de bande passante variable comporte une pluralité de filtres (200.2, 200.3), montés en série et limitant par pas la largeur de bande, et un sélecteur (210) dont les entrées sont reliées au moins partiellement aux bornes de prélèvement de signal entre les filtres (200.2, 200.3).

**6.** Filtre de canal adaptatif selon l'une des revendications précédentes,
**caractérisé en ce que**

- le moyen (30) destiné à commander la largeur de bande passante comporte :

-- un moyen de calcul (35) comprenant au moins deux entrées qui est conçu pour calculer pour chaque entrée une grandeur qui est représentative de la puissance amenée à cette entrée, et
-- un moyen de comparaison (36) qui est conçu pour comparer entre elles des grandeurs calculées pour différentes entrées.

**7.** Filtre de canal adaptatif selon les revendications 5 et 6,
**caractérisé en ce qu'**une ou plusieurs entrées du moyen de calcul (35) sont montées en parallèle avec une ou plusieurs entrées du sélecteur (21, 210).

**8.** Filtre de canal adaptatif selon l'une des revendications 6 ou 7,
**caractérisé en ce que**

- la grandeur calculée par le moyen de calcul (35) pour chaque entrée est

$$P_i = \sum_{k=1,\ldots,k} \left| \mathrm{Re}(x_i(k)) \right| + \left| \mathrm{Im}(x_i(k)) \right| \qquad (i = 1, \ldots, N)$$

où N est le nombre des entrées du circuit de calcul 35, $x_i(k)$ représente les valeurs d'échantillonnage amenées à la $i^{\text{ième}}$ entrée du circuit de calcul 35 et K est le nombre de valeurs d'échantillonnage d'une impulsion de signal.

**9.** Procédé de réglage de la largeur de bande passante variable d'un filtre de canal (20, 200, 200') qui est un filtre passe-bas numérique dans la portion de bande de base de l'unité de réception, ledit procédé comportant les étapes dans lesquelles:

- on mesure une grandeur influencée par l'interférence due au canal voisin à l'aide d'un filtre passe-bande numérique (200.4) monté en parallèle avec le filtre de canal (200') de largeur de bande passante variable,
- on règle la largeur de bande passante du filtre de canal (20, 200, 200') en fonction de la grandeur mesurée.

**10.** Procédé suivant la revendication 9, dans lequel l'étape de mesure comprend le fait de calculer au moins deux grandeurs ($P_1,P_2$), qui sont caractéristiques des puissances de signal d'au moins deux signaux filtrés par des filtres différents.

**11.** Procédé selon la revendication 9 ou 10, dans lequel le réglage de la largeur de bande passante du filtre de canal (20, 200, 200') comporte les étapes dans lesquelles:

- on compare les grandeurs mesurées et le cas échéant adaptées de façon appropriée,
- on commande un sélecteur (21, 210) en fonction du résultat de la comparaison.

**12.** Procédé selon l'une des revendications 9 à 11, dans lequel la durée de la mesure correspond à la durée d'une impulsion de signal.

Fig. 1

Fig. 2

11

Fig. 3

Fig. 4

Fig. 5